# EUROPÄISCHE PATENTSCHRIFT

(11) **EP 1 191 127 B1**
(45) Veröffentlichungstag und Bekanntmachung des Hinweises auf die Patenterteilung: **13.10.2004**
(21) Anmeldenummer: 00120884.2
(22) Anmeldetag: 26.09.2000
(51) Int. Cl.: C25D 5/02, C23C 18/16, C25D 5/54, C25D 5/56, H05K 3/18

(54) **Verfahren zur selektiven Metallisierung dielektrischer Materialien**
Process for selective metallization of dielectric materials
Procédé pour la métallisation selective de matériaux dielectriques

(43) Veröffentlichungstag der Anmeldung: 27.03.2002
(73) Patentinhaber: Enthone-OMI (Deutschland) GmbH, 42699 Solingen (DE); LPKF Laser & Electronics AG, 30827 Garbsen (DE)
(72) Erfinder: Hupe, Jürgen, Dr., 40764 Langenfeld (DE); Kronenberg, Walter, Dr., 51065 Köln (DE); Kickelhain, Jörg, Dr.Ing., 31535 Neustadt am Rübenberge (DE); Meier, Dieter, Dr., 31542 Bad Nenndorf (DE)
(74) Vertreter: Stenger, Watzke & Ring Patentanwälte

(56) Entgegenhaltungen:
- EP-A- 0 641 152
- EP-A- 0 647 729
- EP-A- 0 711 102
- DE-A- 19 822 075
- DE-C- 3 843 230
- US-A- 4 783 243
- US-A- 4 882 200
- US-A- 4 919 768
- US-A- 5 368 717
- US-A- 5 415 762
- US-A- 5 545 308
- US-A- 5 919 402
- US-A- 5 935 405
- FELDMANN K ET AL: "EXCIMERLASERSTRUKTURIERUNG UND ADDITIVE METALLISIERUNG VON THERMOPLASTEN" F & M FEINWERKTECHNIK MIKROTECHNIK MIKROELEKTRONIK,DE,CARL HANSER GMBH & CO, Bd. 106, Nr. 3, 1. März 1998 (1998-03-01), Seiten 150-154, XP000773997 ISSN: 0944-1018
- MYASHITA HARUO: "Partial plating of plastic products" CHEMICAL ABSTRACTS + INDEXES,US,AMERICAN CHEMICAL SOCIETY. COLUMBUS, Bd. 119, Nr. 12, 20. September 1993 (1993-09-20), XP000405832 ISSN: 0009-2258

## Beschreibung

Die vorliegende Erfindung beschreibt ein Verfahren zur selektiven Metallisierung von dielektrischen Materialien, wie sie in der Elektronik zur Anwendung kommen. Bei den so gefertigten Produkten handelt es sich beispielsweise um Leiterplatten, Verdrahtungselemente, Chipcarrier, Interposer, Leadframes oder auch gesamte Baugruppen. Im folgenden wird der Stand der Technik primär für die Fertigung von Leiterplatten beschrieben.

Leiterplatten sind Verdrahtungsträger, welche eine Verdrahtungsstruktur (üblicherweise aus drucktechnisch hergestellten dünnen Kupferschichtengedruckte Schaltungen-) auf einem isolierenden Trägermaterial/Basismaterial aufweisen und der Aufnahme der Bauelemente dienen. Die Ausführungsformen solcher Leiterplatten sind mannigfaltig und umfassen z.B. starre, flexible oder starrflexible, gebohrte oder nicht gebohrte, durchkontaktierte oder nicht durchkontaktierte Basismaterialien. Je nach Lagen und Zahl der Verdrahtungsebenen spricht man von einseitigen, doppelseitigen oder mehrlagigen Leiterplatten; letztere auch Multilayer genannt. Auch dreidimensionale Schaltungen sind bekannt, bei denen die Schaltungsstrukturen auf mehr als zwei Ebenen verlaufen.

So sind z.B. für die Produktion von Leiterplatten seit vielen Jahren verschiedene Methoden in verschiedenen Ausführungen bekannt (z.B. Günther Hermann, Handbuch der Leiterplattentechnik, Eugen Leuze Verlag, 1982, D-88348 Saulgau).

Bei der einfachsten, ursprünglichen Variante wird von kupferkaschierten dielektrischen Materialien ausgegangen, auf die durch Siebdruck oder auf phototechnischem Weg ein Positivdruck in Form des gewünschten Leiterbilds aufgebracht wird. Dieser Positivdruck dient im nachfolgenden Ätzschritt als Schutzschicht (Ätzresist). Die freiliegenden Kupferbereiche, die nicht durch ein derartiges Ätzresist geschützt sind, werden unter Verwendung geeigneter Ätzlösungen entfernt. Das abgeätzte Kupfer fällt als Abfallprodukt an. Der Ätzresist wird anschließend unter Verwendung von anorganischen oder organischen Lösungsmitteln gestrippt.

In weiteren Ausführungen dieser sogenannten Subtraktivtechnik wird durch Siebdruck oder auf phototechnischem Weg zunächst ein Negativdruck des Leiterbilds als Galvanoresist auf dem zu metallisierenden dielektrischen Material erzeugt. Anschließend werden die Leiterzüge galvanisiert, indem die Leiterbahnen bis zur gewünschten Schichtdicke aufmetallisiert werden (zumeist Kupfer). Die Bereiche, in denen die Leiterzüge nicht verlaufen, sind durch den Galvanoresist geschützt. Anschließend wird üblicher Weise galvanotechnisch ein Metallresist in Form von z.B. einer Zinn- oder Zinn-Blei-Schicht auf die metallisierten Leiterzüge aufgebracht, welche die Leiterbahnen bei der nachfolgenden substraktiven Entfernung (Ätzen) der ursprünglichen Kupferkaschierung schützt. Anschließend wird der Metallresist entfernt. Auch weitere Ausführungsvarianten sind bekannt. Anzumerken ist jedoch, daß diese Methode nicht für die Erzeugung von feinen und feinsten (< 50 µm) Leiterbahnen geeignet ist, da der Ätzangriff nicht nur in die Tiefe sondern auch seitlich auf die Flanken der zukünftigen Leiterzüge erfolgt, das sogenannte Phänomen der Unterätzung, mit den sich daraus ergebenden technischen Nachteilen des Kantenabbruchs sowie der Möglichkeit späterer elektrischer Kurzschlüsse. Der Unterätzungsgrad wird um so stärker, je dicker die abzuätzende Kupferschicht ist.

Um das Problem der partiellen Unterätzung zu umgehen, wird häufig auf die Semiadditivmethode zurückgegriffen, die unkaschiertes Basismaterial verwendet, auf das eine dünne galvanische Leitschicht, im allgemeinen außenstromlos abgeschiedenes Kupfer, aufgebracht wird. Im Wesentlichen ähnelt die Weiterverarbeitung den oben beschriebenen Verfahren mit dem Unterschied, daß kein sogenannter positiver Ätzresist aufgebracht wird. D.h. es werden nur die gewünschten Bereiche der Leiterplatte galvanisch mit Kupfer verstärkt. Anschließend werden die unterschiedlich dicken Kupferbereiche um das Maß der anfänglichensaußenstromlosen Verkupferung abgeätzt. Kupfer fällt daher auch bei dieser Methode als Abfallprodukt an. Ferner bedarf es besonderer Sorgfalt hinsichtlich einer sehr gleichmäßigen Schichtdickenverteilung des elektrolytisch aufzubringenden Kupfers.

Die Volladditivtechnik verzichtet gänzlich auf das Kupferätzen, da Kupfer nur auf den erforderlichen Stellen wie Leiterzüge, Lötaugen etc. aufgebracht wird. Daher findet auch diese Methode ein weites Anwendungsfeld. Aufgrund der fehlenden Kontaktierungsmöglichkeiten erfolgt das Verkupfern außenstromlos. Dabei wird zumeist auf das unkaschierte Dielektrikum eine Haftvermittlungs- und Aktivierungsschicht aufgetragen, in der Katalysatorkeime zum Einleiten der außenstromlosen Verkupferung enthalten sind. Nach Abdeckung aller nicht zu verkupfernden Bereiche mittels einer Siebdruck- oder Photomaske erfolgt ein Aufschließen des Haft- und Aktivierungsmittels, so daß eine außenstromlose Verkupferung direkt angeschlossen werden kann.

Die Masken, welche die diskreten Leiterbahnen erzeugen, können im Siebdruckverfahren oder auf phototechnischem Weg erzeugt werden. Gemeinsam ist Ihnen, daß jeweils eine individuelle Maske für jedes zu erzeugende Leiterbahnenmuster angefertigt werden muß. Bei Strukturierung mittels eines Photoprozesses werden sogenannte "Photolacke" als lichtempfindliche Materialien auf das zu metallisierende Dielektrikum aufgebracht. Anschließend werden nur bestimmte Bereiche belichtet, welche je nach verwendeter Substanz das Positiv oder das Negativ der gewünschten Leiterbahnen darstellen.

Neben der Leiterbahnstrukturierung durch fototechnische Prozesse wird, vor allem auch für dreidimensionale Teile wie z.B. bei den sogenannten Molded Interconnect Devices, die Verwendung einer Immersions-Zinn-Schicht mit anschließender Strukturierung mittels Laser in Betracht gezogen. Der Einsatz des Lasers stellt dabei einen zusätzlichen Schritt bei einer Subtraktivtechnologie dar. Nachteilig ist vor allem der zeitliche Aufwand für die Strukturierung. Einerseits muß die Zinnschichtdicke ausreichend Ätzschutz bieten, andererseits soll die Schicht möglichst gering sein, um eine schnelle Laserablation zu gewährleisten.

Verfahren, die dünnste Metallfilme ablatieren, werden heute bereits in der Fertigung zur Herstellung von Leiterplatten eingesetzt. Meist wird dabei von auf Kupfer aufgebrachten Zinnschichten ausgegangen, die mittels Laser strukturiert werden und bei denen dann das verbleibende Kupfer durch einen Ätzvorgang entfernt wird (E. Tadic: "Haaresbreite Feinstrukturen für zukünftige Produktgestaltungen" SMT Ausgabe 1-2/2000, 12).

Auch für dreidimensionale Körper sind bereits Verfahren bekannt, bei denen unter Einsatz der Lasertechnik feinste Strukturen erzeugt werden. So werden Verfahren zur laserunterstützten additiven Metallisierung von Thermoplasten für 3D-MIDs beschrieben, bei dem von dotierten Kunststoffen ausgegangen wird und die mittels Laser aktivierbar sind und für eine nachfolgende stromlose Metallisierung zum Leiterbahnaufbau geeignet sind (SMT Ausgabe 4/2000,20).

Auch andere Verfahren sind bekannt, bei denen unterschiedliche Metallschichten mittels eines Lasers ablatiert werden. So wird von D. Meier ein Verfahren beschrieben, bei dem dünne Goldschichten mittels UV-Laser in einem Maskenprojektionsverfahren ablatiert werden und anschließend stromlos verstärkt werden ("Laser Structuring of Fine Lines", 5^{th} Annual Conference on Flexible Materials Denver/USA 1999, Proceedings). Auch die Laserablation, speziell mit Palladium-dotierten organischen Schichten, ist bekannt (J. Kickelhain: Promotionsarbeit an der Universität Rostock 1999). All diesen Verfahren ist jedoch der Nachteil gemeinsam, daß im Anschluß an die Laserstrukturierung eine stromlose additive Metallisierung zur Verstärkung des Leiterbahnbilds erfolgt.

Ferner haben seit einiger Zeit leitfähige Polymere ihren Platz bei der Metallisierung von Dielektrika gefunden. Speziell zur Durchkontaktierung und Fertigung von zweiund mehrlagigen Leiterplatten in der sogenannten Direct Plating Technik finden sie Anwendung. Dabei handelt es sich um eine Substraktivtechnik, bei der nach Aktivierung des Dielektrikums mit dem jeweiligen leitenden Polymer direkt eine galvanische Metallisierung erfolgt (PCT/EP 89/00204). Nachteilig ist - speziell bei flächiger Metallisierung - die relativ geringe elektrische Leitfähigkeit dieser leitenden Polymere.

Auch sind Verfahren bekannt, die auf Basis leitender Polymere eine selektive direkte galvanische Metallisierung vorschlagen. So beschreibt das US-Patent 5,935,405 ein Verfahren, bei dem das Basismaterial mit einem Primer und leitfähigen Polymeren beschichtet wird. Um die Struktur zu erzeugen, wird ein fotostrukturierbarer Galvanoresist verwendet. Nach der galvanischen Beschichtung wird der Resist zunächst gestrippt und dann das leitende Polymer, das sich unterhalb des Resists befunden hatte, entfernt. Nachteilig ist dabei die Verwendung eines fotostrukturierbaren Galvanoresists, da zur Realisierung von Fein- oder Feinstlinestrukturen hohe Anforderungen an die Reinraumtechnik gestellt werden, sowie die später notwendige Entfernung von leitendem Polymer.

Das deutsche Patent DE 38 43 230 beschreibt ein Verfahren zur Herstellung eines metallischen Musters auf einer Unterlage, insbesondere zur Laserstrukturierung von Leiterbahnen. Bei dem Verfahren wird ein dünner Metallfilm auf das zu metallisierende Dielektrikum aufgebracht, was beispielsweise durch Aufdampfen erfolgen kann. Der aufgebrachte Metallfilm ist dünn und besitzt für die verwendete elektromagnetische Strahlung des Lasers eine gewisse Durchlässigkeit. Eine Maske bestimmt das Muster der Leiterbahn. Bei der Strukturierung werden die überflüssigen Bereiche des Metallfilms an den durch die Maske vorgegebenen Bereichen mittels eines einzelnen Laserimpuls abgetragen. Die elektromagnetische Strahlung durchdringt den Metallfilm und wird in der Oberflächenschicht der Unterlage absorbiert, wobei chemische Bindungen des als Unterlage für den Metallfilm verwendeten Dielektrikums aufgebrochen und explosionsartig unter Mitnahme des unmittelbar darüber liegenden Metallfilms fortgerissen werden.

Die US Patentschrift US 4,882,200 offenbart ein Verfahren in welchem das Dielektrikum mit einer Aktivierungsschicht belegt wird. Als Aktivator wird ein im außenstromlosen Verfahren einsetzbarer verwendet. Dies können Metallaktivatoren wie beispielsweise Palladium und/oder Palladiumkomplexe sein. Die Aktivierungsschicht wird mit einem Laser vorzugsweise unter Zuhilfenahme einer Maske zur Musterbildung ablattiert. Im Anschluß an die Darstellung der leitenden Struktur mittels Ablation folgt eine außenstromlose Metallisierung.

Die europäischen Patentanmeldungen EP 0 641 152 sowie EP 0 711 102 offenbaren ein Verfahren in welchem ein Dielektrikum haftfest mit einem dünnen Metallfilm belegt wird. Die Stärke des aufgebrachten Metallfilms ist für das Gelingen des Verfahrens entscheidend. Der Metallfilm sollte eine Stärke von 0,2 bis 2 µm, vorzugsweise 0,3 bis 1 µm aufweisen. Innerhalb dieses Bereichs wird gewährleistet, daß der Laserstrahl die Oberfläche des Dielektrikums nicht beschädigt und andererseits die Leitfähigkeit des Metallfilms erhalten bleiben. Die Konturen des Leiterbahnverlaufs werden mittels eines Lasers erzeugt. Die Stärke des Lasers wird so gewählt, daß dieser den Metallfilm an den beabsichtigten Stellen entfernt, ohne daß Dielektrikum zu beschädigen. Das vorgegebene Leiterbahnbild wird mittels eines computergesteuerten Lasers erzeugt. Bei diesem Verfahren werden die Leiterbahnen mittels eines Lasers aus dem Metallfilm herausgeschnitten, so daß zum einen der zu metallisierenden Leiterbahnverlauf im leitenden Verbund entsteht und ferner die Reste des dünnen Metallfilms isoliert vorliegen. Die so erzeugten Leiterbahnstrukturen werden bis zur Erreichung der gewünschten Stärke aufmetallisiert. Im anschließenden Ätzschritt werden die Reste des dünnen Metallfilms entfernt und nur die Leiterbahnen übrig behalten.

Auch die europäische Patentanmeldung EP 0 647 729 A1 offenbart ein Verfahren zur außenstromlosen Aufbringung von Metallstrukturen auf ein Dielektrikum. Dieses Verfahren ist gemäß den Beschreibungen insbesondere zur Herstellung der schwarzen Matrix auf Planscheiben von Display-Vorrichtungen geeignet. Bei diesem Verfahren wird auf Photoresiste oder organische Lösungsmittel verzichtet. Das Dielektrikum (hier Glas) wird aktiviert, indem es mit einer wäßrigen, kolloidalen Palladiumdispersion in Kontakt gebracht wird, welche mit einem wasserlöslichen Polymer stabilisiert ist. Die Palladiumkeime werden an dem Dielektrikum absorbiert. Das aktivierte Dielektrikum wird teilweise mit einem gepulsten Laserstrahl belichtet, wobei der Laserstrahl Energien aufweist die ausreichend sind um Palladiumkeine von den gewünschten Teilbereichen zu entfernen. Im Anschluß an die Laserbehandlung werden die nicht bestrahlten Bereiche des Dielektrikums, welche noch mit dem Aktivator belegt sind, in einem außenstromlosen Bad aufmetallisiert.

Myashita Haruo offenbart in Chemical Abstracts + Indexes, US, American Chemicals Society, Columbus, Bd. 119, Nr. 12 vom 20. September 1993 unter dem Titel "Partial plating of plastic products" ein Verfahren zur partiellen Metallisierung von Kunststoffteilen. Dabei werden die Kunststoffoberflächen in einem ersten Schritt mit einem Ätzmittel angerauht. Die aufgerauhte Oberfläche wird im Anschluß mit einer Aktivierungslösung in Kontakt gebracht, so daß die katalytischen Metallkeime an der Oberfläche haften. Die Oberfläche wird dann außenstromlos metallisiert. Mit einem Laser wird der Metallfilm teilweise entfernt, so daß der dielektrische Untergrund freigelegt wird. Die verbleibenden Reste des außenstromlos aufgebrachten Metallfilms werden im Anschluß elektrolytisch metallisiert.

Das US-Patent US-A-5545308 beschreibt die Verwendung von leitenden Polymerfilmen aus photsensitiven Zusammensetzungen von Pyrrol und einem Elektronenakzeptor, welche selektiv UV-Licht, Laserlicht oder Elektronenstrahlung ausgesetzt werden. Anwendung findet ein solches Verfahren in der Herstellung von Leiterbahnen und Durchkontaktierungen. Verfahrensgemäß werden nach der Bildung der leitenden Polymerstrukturen auf den Leiterplatten diese mittels Palladium aktiviert und anschließend elektrolytisch metallisiert. Beispiel 7 dieser Patentschrift zeigt die Verwendung eines 4:1 Gemisches bzw. eines 8:1 Gemisches von Pyrrol und Silbernitrat zur Erzeugung von leitenden Polymerstrukturen mittels Laser auf einem Alluminumsubstrat. Des weiteren wurde in diesem Beispiel ein 4:1 Gemsich aus Pyrrol und Silbemitrat mittels eines 10-Nanometer breiten Elektronenstrahls photopolymerisiert. Alle verwendeten Zusammensetzungen enthalten zusätzlich Acetonitril.

Beipiel 8 dieser Patentanmeldung beschreibt die Struktur der mittels Photopolymerisation bzw. Elektropolymerisation erhaltenen Polymerfilme als dicht, nicht faserig und volumenfüllend, wobei die photochemisch erzeugten Polymere eine offenere Struktur mit einigen Leerstellen aufwiesen.

Die US-Patentschrift US-A-5919402 offenbart ein zu den Beispielen der US-A-5545308 im wesentlichen vergleichbare Erfindung.

Der Erfindung liegt die **Aufgabe** zugrunde, einen verfahrenstechnisch einfachen, sicheren, kostengünstigen und umweltschonenden Weg zur selektiven Metallisierung von Dielektrika zu finden, der eine präzise Strukturierung im Bereich weniger µm erlaubt und darüber hinaus auf jegliche Anwendung von Resisten verzichtet.

Eine technische **Lösung** liefert das erfindungsgemäße Verfahren, indem das zu metallisierende jeweilige Dielektrikum mit einer Aktivierungsschicht aus leitendem Material haftfest belegt wird und durch eine anschließende Laserbehandlung eine Strukturierung der Aktivierungsschicht dergestalt erfolgt, daß ohne Verwendung einer Maske diskrete leitende Strukturen entstehen, welche anschließend elektrolytisch metallisiert werden, wobei die Aktivierungsschicht entweder aus einem mit Pd- oder Cu-Keimen belegten leitenden Polymer, Metallsulfiden oder Metallpolysulfiden besteht.

Durch das erfindungsgemäße Verfahren werden daher in vorteilhafter Weise Beschränkungen des Stand der Technik überkommen. Mit der Erfindung werden verfahrensseitige Maßnahmen vorgeschlagen, die das Verfahren technisch vorteilhaft, überaus wirtschaftlich und effektiv machen. Das Verfahren wird im folgenden exemplarisch für die Fertigung von Leiterplatten beschrieben, ohne es jedoch auf dieses Elektroniksegment zu begrenzen.

Gemäß eines ersten Lösungsansatz wird demzufolge die elektrolytische Galvanisierung unter Anlegung eines Stroms durch das erfindungsgemäße Verfahren in vorteilhafter Weise dadurch ermöglicht, daß eine dünne haftfeste und elektrisch leitende Aktivierungsschicht auf das zu metallisierende Dielektrikum aufgebracht wird. Diese leitende Aktivierungsschicht ermöglicht die elektrolytische Galvanisierung.

Die Aktivierungsschicht kann vielartig gestaltet sein, sofern eine ausreichende elektrische Leitfähigkeit gewährleistet ist. Vorteilhafter Weise können polymerisierte oder copolymerisierte Pyrrol, Furan, Tiophen und/oder andere Derivate eingesetzt werden. Insbesondere vorteilhaft ist jedoch die Verwendung eines leitenden Polymers auf Basis eines Polythiophen Derivates (DMS-E). Ferner können auch Metallsulfid- und/oder Metallpolysulfidschichten sowie Pd-und/oder Kupfer-Katalysatoren Anwendung finden. Des weiteren besteht auch die Möglichkeit, dünne Metallfilme auf das Substrat aufzubringen. Dabei können z.B. Kupferschichten aufgebracht werden.

Dabei ist insbesondere vorteilhaft, die Schichtdicke der Aktivierungsschicht in einem Bereich von ca. 0,1µm aufzubringen. In vorteilhafter Weise offenbart das erfindungsgemäße Verfahren eine Möglichkeit zur Strukturierung der leitenden Aktivierungsschicht dergestalt, daß diskrete, leitende Sturkturen entstehen. Hierfür wird mit der Erfindung eine neue Vorgehensweise vorgeschlagen. Gemäß eines besonders vorteilhaften Merkmals der vorliegenden Erfindung erfolgt die präzise Strukturierung der Aktivierungsschicht mittels eines Lasers. Die verbleibenden Strukturen der Aktivierungsschicht sind weiterhin elektrisch leitend und können - solange ein Leiterbahnverbund besteht - galvanisch metallisiert werden. Dabei können isolierte Bereiche mittels sogenannter Hilfsleiter zu einem künstlichen Leiterbahnverbund verbunden werden. Die von der Aktivierungsschicht verbleibenden leitenden Strukturen werden im nachfolgenden elektrolytischen Galvanisierungsschritt unter Anlegung eines Außenstroms metallisiert. Für die elektrolytische Galvanisierung der strukturierten Aktivierungsschicht können im erfindungsgemäßen Verfahren diverse Metallelektrolyte verwendet werden, vorzugsweise jedoch Kupferelektrolyte. Die Laser-Ablation ermöglicht somit in vorteilhafter Weise die präzise und individuelle Gestaltung der Leiterbahnen in einem Bereich von wenigen µm. Dabei sieht das erfindungsgemäße Verfahren ferner die Möglichkeit vor, daß die sogenannten Hilfsleiter, die während der Metallisierung als eine Art Strombrücke zwischen isolierten Leiterbahnenbereichen dienten, im Anschluß an die Metallisierung entfernt werden können. Die Zerstörung des künstlichen Leiterbahnverbunds kann z.B. auch durch Laserbehandlung geschehen.

Durch das erfindungsgemäße Verfahren wird daher in vorteilhafter Weise die Möglichkeit eröffnet, auf außenstromlose Metallisierungsbäder, wie sie z.B. bei der Additivtechnik verwendet werden, zu verzichten. Durch diesen Umstand wird auch die Belastung der Umwelt durch Restchemikalien und chemische Abwässer niedrig gehalten. Ferner unterliegen außenstromlos abgeschiedenen Metallschichten in Bezug auf ihre Duktilität klar den wesentlich feinkristallineren und dichteren elektrolytisch gebildeten Metallschichten. Bedingt durch die Tatsache, daß das erfindungsgemäße Verfahren aufgrund der Aktivierungsschicht eine direkte elektrolytische Galvanisierung unter Anlegung eines Außenstroms ermöglicht, wird in vorteilhafter Weise gewährleistet, daß die erforderlichen hohen Duktilitätsanforderungen erfüllt werden, die sicherstellen, daß z.B. durch die thermische Belastung des Lötvorgangs beim späteren Bestücken der Leiterplatten Hülsen- oder Kantenabrisse vermieden werden.

Das erfindungsgemäße Verfahren schließt auch die Möglichkeit zur außenstromlosen Metallisierung ein, sofern es erforderlich und wünschenswert ist. Zur Durchführung muß die verwendete haftfeste Aktivierungsschicht der außenstromlosen Metallisierung dergestalt angepaßt werden, daß die Aktivierungsschicht die zur außenstromlosen Verkupferung erforderlichen Katalysatorkeime enthält und die entsprechende Handhabung angepaßt wird.

Das besondere Merkmal des erfindungsgemäßen Verfahrens, die Leiterbahnstrukturierung mittels eines Lasers vorzunehmen, bietet den weiteren großen Vorteil einer schnellen, individuellen Gestaltung der Leiterbahnen. Dies resultiert in flexibleren Produktionsmöglichkeiten durch z.B. schnelle Reaktion auf etwaige gewünschte Änderungen im Leiterbahnverlauf. Dies wird z.B. dadurch erreicht, daß im Gegensatz zu allen bekannten Verfahren keine Sieb-, Photo- oder anders geartete Masken benötigt werden, die den Umriß der Leiterbahnen erzeugen, da dieser durch den Laser erzeugt wird.

Bedingt durch den Umstand, daß auf herkömmliche Photomasken verzichtet werden kann, ist das erfindungsgemäße Verfahren weiterhin in vorteilhafter Weise dadurch gekennzeichnet, daß auf die Verwendung von Resiststoffen jeglicher Art, welche z.B. die Masken bilden oder Leiterbahnverläufe bei z.B. der Subtraktivtechnik schützen, verzichtet werden kann. Dadurch können sowohl Chemikalien als auch Arbeitsschritte eingespart werden, da sie weder aufgebracht noch anschließend entfernt werden müssen.

Weiterhin offenbart sich der Vorteil, daß durch die exakte Laser-Strukturierung das Risiko eines Wildwachstums der Metallschicht nicht gegeben ist. Dadurch ist gewährleistet, daß die Leiterbahnen exakt gebildet werden, was die Ausschußrate gering hält.

Die durch das erfindungsgemäße Verfahren erzielbare Dichte der Leiterzüge, ihre Anordnungsdichte auf der Leiterplatte sowie ihre hohe Qualität und Präzision sind kennzeichnend für die Vorteile des erfindungsgemäßen Verfahrens, da zum wünschenswerten Einsparen von Masse und Volumen elektronischer Geräte, sowie zwecks Optimierung ihrer Arbeitsgeschwindigkeit, äußerst kurze Leitungswege erforderlich sind. Das erfindungsgemäße Verfahren ist daher insbesondere zur Fertigung von solchen Produkten geeignet, bei denen eine hohe Integrationsdichte gefordert ist. Dies gilt z.B. für Anwendungen in der Computer-, Telekommunikations-, Verbindungs- oder Medizintechnik. Ferner ermöglicht das erfindungsgemäße Verfahren problemlos auch die Herstellung von dreidimensionalen Schaltungen, bei denen die Schaltungsstrukturen nicht mehr nur in zwei Ebenen benötigt werden.

Der im erfindungsgemäßen Verfahren verwendete Laser kann z.B. ein KrF-, XeC1-, oder ein Nd-YAG-Laser sein. Ferner ist auch die Verwendung von anderen Lasern denkbar, sofern die notwendige präzise Laser-Ablation durchführbar ist.

Das erfindungsgemäße Verfahren offenbart desweiteren die Möglichkeit zur spezifischen Steuerung des Lasers, z.B. dergestalt, daß das Gerät an ein Steuerungsmodul jeglicher Art angeschlossen werden kann. Dieses Steuerungsmodul kann ein z.B. Computer sein.

Das erfindungsgemäße Verfahren bietet durch die exakte Strukturierung den Vorteil, bei der Metallisierung weniger Rohstoffe als bei den herkömmlichen Verfahren zu verbrauchen, da Kupfer additiv nur an den Stellen aufgebracht wird, an denen es erforderlich ist. Weiterhin ergibt sich aus diesem Umstand ein geringer Chemikalienverbrauch, da z.B. auch auf Ätz- und Strip-Schritte weitgehend verzichtet werden kann. Diese Besonderheiten des erfindungsgemäßen Verfahrens führen letztlich zu einer vorteilhaften Kosteneinsparung und einer geringeren Umweltbelastung, da weniger Chemieabfälle anfallen.

Weiterhin ist ein großer verfahrenstechnischer Vorteil gegenüber allen Verfahren, die auf photochemischen Prozessen basieren darin begründet, daß bei dem erfindungsgemäßen Verfahren auf jegliche lichtschützende Maßnahmen verzichtet werden kann. So entfällt durch die Verwendung eines Lasers die Notwendigkeit, daß spezielle Lagerkapazitäten und Werkräume für die lichtempfindlichen Photolacke zur Verfügung gestellt werden müssen.

Weitere Vorteile und Merkmale ergeben sich aus den nachfolgenden Beispielen, die das erfindungsgemäße Verfahren näher erläutern:

### 1. Beispiel

Unkaschiertes Basismaterial (z.B. BR 4) wird entsprechend dem DMS-E-Verfahren mit leitendem Polymer belegt. Der im folgenden beschriebene Arbeitsgang ist daher durchzuführen:

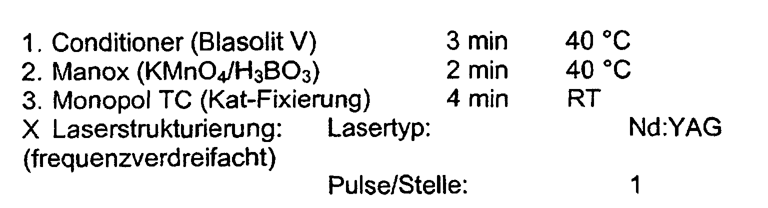

### 2. Beispiel

Unkaschiertes Basismaterial (z.B. BFR 4) wird entsprechend dem DMS-E-Verfahren mit einem leitfähigen Polymer belegt. Der im 1. Beispiel beschriebene Arbeitsgang (Schritt 1 bis 3) wird übernommen und durch die folgenden Arbeitsschritte ergänzt:

| | | |
|---|---|---|
| 4. Conditioner PE | 3 min | RT |
| 5. Ultraplast 2000 (Pd-Kat) | 4 min | 40 °C |
| 6. Generator (Cu-haltige Lösung) | 5 min | 63 °C |

Im Anschluß erfolgt der Arbeitsschritt

| | | |
|---|---|---|
| X) Laserstrukturierung | Lasertyp | KrF |
| | Wellenlänge | 248nm |
| | Energiedichte auf Substrat | 100mJ/cm² |
| | Laserenergie | 450mJ |
| | Pulse/Stelle | 2 |

### 3. Beispiel

Basismaterial mit Kupfer kaschiert und mit einem Speziallack für SBU-Schaltungen versehen (z.B. LDD 9056 der Firma Enthone), wird wie nachfolgend beschrieben, behandelt.

| | | | |
|---|---|---|---|
| 1. Queller | 10 min | 80 °C | |
| 2. KMnO₄ alkalisch | 13 min | 80 °C | |
| 3. Remover Mn (schwefelsauer, H₂O₂) | | 2 min | RT |

Im Anschluß an diesen Arbeitsgang werden die Leiterplatten wie im Beispiel 2 beschrieben behandelt.

### 4. Beispiel

Unkaschiertes Basismaterial (z.B. FR 4) wird wie folgt behandelt:

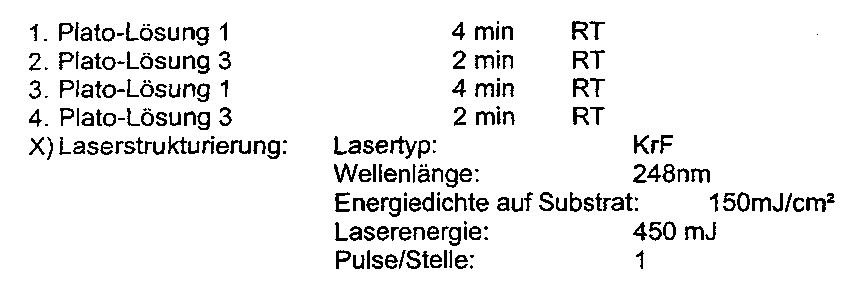

### 5. Beispiel

Basismaterial mit Kupfer kaschiert und mit einem Speziallack für SBU-Schaltungen versehen (z.B. LDD 9056 der Firma Enthone) wird wie im folgenden beschrieben behandelt:

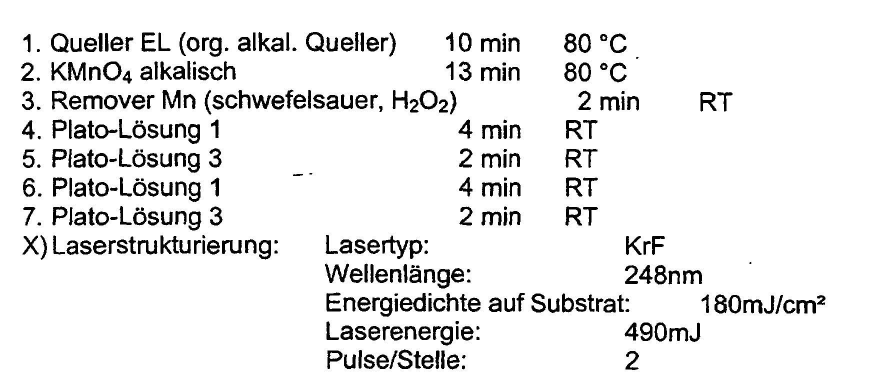

### 6. Beispiel

Unkaschiertes Basismaterial (z.B. FR 4) wird wie folgt behandelt:

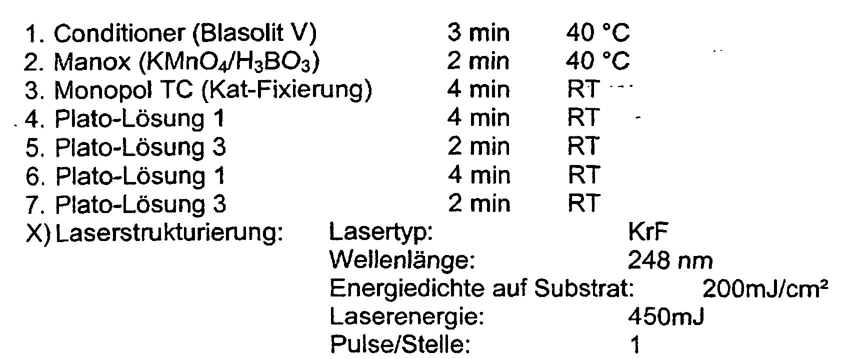

### Beispiel 6a.

Es besteht auch die Möglichkeit den Arbeitsgang so zu variieren, daß die Arbeitsschritte wie folgt durchgeführt werden:

Zuerst werden die Behandlungsschritte 4 bis 7 durchgeführt und im Anschluss daran werden die Behandlungsschritte 1 bis 3 durchgeführt. Danach wird der Behandlungsschritt X), Laserstrukturierung, durchgeführt.

### 7. Beispiel

Basismaterial mit Kupfer kaschiert und mit einem Speziallack für SBU-Schaltungen versehen (z.B. LDD 9056 der Firma Enthone), wird wie folgt behandelt:

| | | | |
|---|---|---|---|
| 1. Queller EL (org. alkal. Queller) | 10 min | 80 °C | |
| 2. KMnO₄ alkalisch | 13 min | 80 °C | |
| 3. Remover Mn (schwefelsauer, H₂O₂) | | 2 min | RT |

Im Anschluß daran folgen die Arbeitsschritte 1. bis X) aus Beispiel 6.

### Beispiel 7a.

Es besteht auch hier die Möglichkeit den Arbeitsgang so zu variieren, daß die Behandlungsschritte wie folgt durchgeführt werden:
Zuerst werden die Behandlungsschritte 1 bis 3 durchgeführt. Im Anschluß daran werden die Behandlungsschritte 4 bis 7 aus Beispiel 6 und daran anschließend die Behandlungsschritte 1 bis 3 aus Beispiel 6 durchgeführt. Danach wird der Behandlungsschritt X), Laserbehandlung, durchgeführt.

### 8. Beispiel

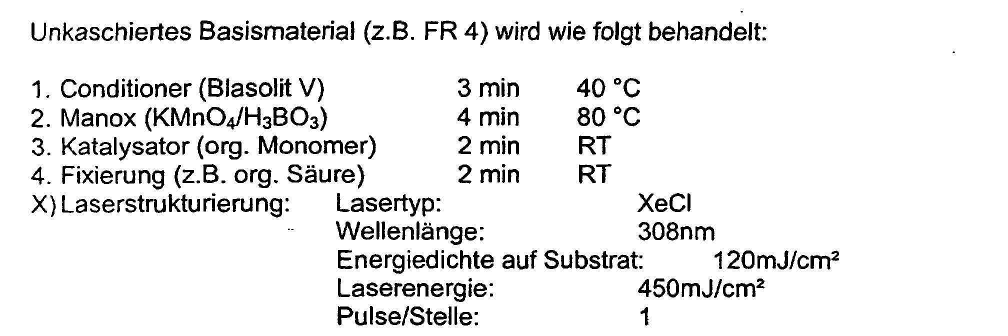

Vor der Laserstrukturierung können die folgenden Behandlungsschritte durchgeführt werden:

| | | |
|---|---|---|
| 5. Conditioner PE | 3 min | RT |
| 6. Ultraplast 2000 (Pd-Kat) | 4 min | 40 °C |
| 7. Generator (Cu-haltige Lösung) | 5 min | 63 °C |

### 9. Beispiel

Basismaterial mit Kupfer kaschiert und mit einem Speziallack für SBU-Schaltungen versehen (z.B. LDD 9056 der Firma Enthone) wird wie folgt behandelt:

| | | | |
|---|---|---|---|
| 1. Queller EL (org. alkal. Queller) | 10 min | 80 °C | |
| 2. KMnO₄ alkalisch | 13 min | 80 °C | |
| 3. Remover Mn (schwefelsauer, H₂O₂) | | 2 min | RT |

Im Anschluß daran werden die Behandlungsschritte 1. bis 4. aus Beispiel 8 durchgeführt, anschließend erfolgt die Laserstrukturierung. Es besteht auch die Möglichkeit die Arbeitsschritte 5. bis 7. vor der Laserstrukturierung durchzuführen.

Als Variation besteht auch die Möglichkeit, die Behandlungsschritte wie folgt zu variieren:
Basismaterial mit Kupfer kaschiert und mit einem Speziallack für SBU-Schaltungen versehen (z.B. LDD 9056 der Firma Enthone) wird wie folgt behandelt:

| | | | |
|---|---|---|---|
| 1. Queller EL (org. alkal. Queller) | 10 min | 80 °C | |
| 2. KMnO₄ alkalisch | 13 min | 80 °C | |
| 3. Remover Mn (schwefelsauer, H₂O₂) | | 2 min | RT |
| 4. Plato-Lösung 1 | 4 min | RT | |
| 5. Plato-Lösung 3 | 2 min | RT | |
| 6. Plato-Lösung 1 | 4 min | RT | |
| 7. Plato-Lösung 3 | 2 min | RT | |
| 8. Conditioner (Blasolit V) | 3 min | 40 °C | |
| 9. Manox (KMnO₄/H₃BO₃) | 4 min | 80 °C | |
| 10.Katalysator (org. Monomer) | 2 min | RT | |
| 11.Fixierung (z.B. org. Säure) | 2 min | RT | |

Vor der Laserstrukturierung können wahlweise noch die folgenden Arbeitsschritte in den Prozeßablauf einbezogen werden:

| | | |
|---|---|---|
| 12. Conditioner PE | 3 min | RT |
| 13. Ultraplast 2000 (Pd-Kat.) | 4 min | 40 °C |
| 14. Generator (Cu-haltige Lösung) | 5 min | 63 °C |

Nach der Laserstrukturierung erfolgt die folgende Weiterbehandlung:

Die Leiterplatten werden in einem handelsüblichen Kupfer- und/oder Nickelelektrolyten so lange galvanisiert, bis das auf den Leiterplatten befindliche Leiterbild vollständig mit Metall versehen ist. Mit dem beschriebenen Verfahren ist es möglich, Leiterzüge und Leiterbahnabstände von wenigen µm zu realisieren.

## Patentansprüche

1. Verfahren zur selektiven Metallisierung von dielektrischen Material, **dadurch gekennzeichnet, daß**
das jeweilige Dielektrikum mit einer Aktivierungsschicht aus leitendem Material haftfest belegt wird und durch eine anschließende Laserbehandlung eine Strukturierung der Aktivierungsschicht dergestalt erfolgt, daß ohne Verwendung einer Maske diskrete leitende Strukturen entstehen, welche anschließend elektrolytisch metallisiert werden, wobei die Aktivierungsschicht entweder aus einem mit Pd- oder Cu- Keimen belegten leitenden Polymer, Metallsulfiden oder Metallpolysulfiden besteht.

2. Verfahren nach Anspruch 1, **dadurch gekennzeichnet, daß** es in der Elektronik bei der Herstellung von Elementen und Baugruppen Anwendung findet.

3. Verfahren nach Anspruch 1 und 2, **dadurch gekennzeichnet, daß** es in der Herstellung von Leiterplatten Verwendung findet.

4. Verfahren nach Anspruch 1 bis 3, **dadurch gekennzeichnet, daß** als dielektrische Materialien Kunststoffe und/oder Keramik verwendet werden.

5. Verfahren nach einem oder mehreren der vorherigen Ansprüche, **dadurch gekennzeichnet, daß** das leitende Polymer aus polymerisierten oder kopolymerisiertem Pyrrol, Furan, Thiophen und/oder deren Derivaten besteht.

6. Verfahren nach einem oder mehreren der vorherigen Ansprüche **dadurch gekennzeichnet, daß** das leitende Polymer Poly-3,4-ethylen-dioxythiophen ist.

7. Verfahren nach einem oder mehreren der vorherigen Ansprüche, **dadurch gekennzeichnet, daß** zur Metallisierung bevorzugt Kupferelektrolyte Verwendung finden.

8. Verfahren nach einem oder mehreren der vorherigen Ansprüche, **dadurch gekennzeichnet, daß** zur Strukturierung ein KrF-, XeCl- oder Nd-YAG-Laser verwendet wird.

9. Verfahren nach einem oder mehreren der vorherigen Ansprüche, **dadurch gekennzeichnet, daß** die leitenden Strukturen während der Metallisierung zerstört oder in ihrer Form erhalten werden.

## Claims

1. Method of selective metallization of dielectric material, **characterized in that** the respective dielectric material is covered adhesively with an activating layer consisting of conductive material and that structuring of the activating layer by a subsequent laser treatment is carried out in such a way that without the use of a mask discrete conductive structures are formed which are subsequently metallised electrolytically, wherein the activating layer consists either of a conductive polymer covered with Pd or Cu nuclei, metal sulphides or metal polysulphides.

2. Method as claimed in Claim 1, **characterised in that** it is applied in the field of electronics for the production of elements and assemblies.

3. Method as claimed in either Claim 1 or Claim 2, **characterised in that** it is applied in the production of printed circuit boards.

4. Method as claimed in any one of Claims 1 to 3, **characterised in that** plastics and/or ceramics are used as dielectric materials.

5. Method as claimed in one or more of the preceding claims, **characterised in that** the conductive polymer consists of polymerised or copolymerised pyrrole, furan, thiophene and/or derivatives thereof.

6. Method as claimed in one or more of the preceding claims, **characterised in that** the conductive polymer is poly-3,4-ethylene-dioxythiophene.

7. Method as claimed in one or more of the preceding claims, **characterised in that** copper electrolytes are preferably used for metallisation.

8. Method as claimed in one or more of the preceding claims, **characterised in that** a KrF, XeCl or Nd-YAG laser is used for the structuring.

9. Method as claimed in one or more of the preceding claims, **characterised in that** the conductive structures are destroyed during metallization or are obtained in their form.

## Revendications

1. Procédé pour la métallisation sélective de matériaux diélectriques, **caractérisé en ce que** le matériau diélectrique concerné est revêtu de manière adhérente par une couche d'activation d'un matériau conducteur et qu'un traitement au laser consécutif produit une structuration de la couche d'activation, de manière à réaliser, sans l'utilisation d'un cache, de discrètes structures conductrices qui sont métallisées ensuite par voie électrolytique, la couche d'activation étant formée par un polymère conducteur revêtu de germes Pd ou Cu, des sulfures métalliques ou des polysulfures métalliques.

2. Procédé selon la revendication 1, **caractérisé en ce qu'**il est utilisé en électronique pour la réalisation d'éléments et de groupes de composants.

3. Procédé selon les revendications 1 et 2, **caractérisé en ce qu'**il est utilisé dans la fabrication des plaquettes de circuits imprimés.

4. Procédé selon l'une quelconque des revendications 1 à 3, **caractérisé en ce que** les matériaux diélectriques utilisés sont des matières plastiques et/ou la céramique.

5. Procédé selon une ou plusieurs des revendications précédentes, **caractérisé en ce que** le polymère conducteur est formé par le pyrrole, le furane, le thiophène polymérisés ou copolymérisés et/ou des dérivés de ceux-ci.

6. Procédé selon une ou plusieurs des revendications précédentes, **caractérisé en ce que** le polymère conducteur est un poly-3,4-éthylène-dioxythiophène.

7. Procédé selon une ou plusieurs des revendications précédentes, **caractérisé en ce que** l'on utilise, de préférence, des électrolytes à bain de cuivre pour la métallisation.

8. Procédé selon une ou plusieurs des revendications précédentes, **caractérisé en ce que** la structuration est effectuée au moyen d'un laser KrF, d'un laser XeCl ou d'un laser Nd-YAG.

9. Procédé selon une ou plusieurs des revendications précédentes, **caractérisé en ce que**, pendant la métallisation, les structures conductrices sont endommagées ou sont maintenues dans leur forme.
